Europäisches Patentamt

European Patent Office

Office européen des brevets

(11) Publication number: **0 201 706 B1**

# EUROPEAN PATENT SPECIFICATION

(45) Date of publication of patent specification: **18.09.91**    (51) Int. Cl.⁵: **H01L 27/10**

(21) Application number: **86104427.9**

(22) Date of filing: **01.04.86**

(54) **Dynamic random access memory device having a plurality of improved one-transistor type memory cells.**

(30) Priority: **01.04.85 JP 69511/85**
**28.08.85 JP 190704/85**

(43) Date of publication of application:
**20.11.86 Bulletin 86/47**

(45) Publication of the grant of the patent:
**18.09.91 Bulletin 91/38**

(84) Designated Contracting States:
**DE FR GB**

(56) References cited:
**EP-A- 0 085 988**
**EP-A- 0 108 390**

**PATENT ABSTRACTS OF JAPAN, vol. 7, no. 72 (E-166)[1217], 25th March 1983 & JP-A-58-3260**

(73) Proprietor: **NEC CORPORATION**
**7-1, Shiba 5-chome Minato-ku**
**Tokyo 108-01(JP)**

(72) Inventor: **Hokari, Yasuaki**
**c/o NEC Corporation 33-1, Shiba 5-chome**
**Minato-ku Tokyo(JP)**
Inventor: **Shimizu, Toshiyuki**
**c/o NEC Corporation 33-1, Shiba 5-chome**
**Minato-ku Tokyo(JP)**
Inventor: **Sakamoto, Mitsuru**
**c/o NEC Corporation 33-1, Shiba 5-chome**
**Minato-ku Tokyo(JP)**
Inventor: **Mikoshiba, Hiroaki**
**c/o NEC Corporation 33-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**W-8000 München 26(DE)**

## Description

Background of the Invention:

The present invention relates to a dynamic random access memory (RAM) device having a plurality of improved one-transistor type memory cells.

An integrated circuit formed on a semiconductor substrate, especially on a silicon semiconductor substrate is making a progress towards a high degree of integration and a large capacity, and in the case of an integrated circuit memory device, a degree of integration has increased up to 1 M bits or more. At present, in an IC memory of a dynamic RAM device (DRAM), a memory cell (unit) composed of a single MOS transistor and a single capacitor is suitable for realization of a large capacity and therefore practically employed. In order to realize a DRAM having a memory capacity of 1 megabits per chip or more, it is a key how-small the area per cell, especially the area of the capacitor which occupies a most part of the cell area can be made. To that end, as a measure for reducing an area of a capacitor, a method has been proposed in which a groove is dug in a silicon substrate and a capacitor is formed by making use of an inner wall and a bottom surface of this groove in a report entitled "A CORRUGATED CAPACITOR CELL (CCC) FOR MEGABIT DYNAMIC MOS MEMORIES" by H. Sunami el al. in 1982 International Electron Devices Meeting, Technical Digest P.P. 806-808. The memory cell mentioned above can realize a high integration to some extent since the side wall of the groove is utilized as the capacitor section. However, in this structure, electric charges are stored in an inversion layer of a conductivity type opposite to that of the semiconductor substrate produced along the outside of the groove. Therefore, if the interval between memory cells, that is, between grooves is shortened for the purpose of realizing further high integration, the electric charges stored in an inversion layer along one groove of one memory cell are apt to be transferred inconveniently to an adjacent groove of an adjacent memory cell. Moreover, when the semiconductor substrate is irradiated with ionizing radiations such as α-rays and the like, as the generated carriers by the radiations are liable to gather at the inversion layer the stored information are apt to disappear. As a measure for resolving these problems, a memory device in which electric charge is stored on the side of an electrode within the groove has been proposed in EUROPEAN PATENT APPLICATION Publication number 0 108 390.

In the proposed device, a high impurity region of the same conductivity type as that of the semiconductor substrate is provided outside the groove such that it surrounds all side of the groove from the bottom to the major surface of the substrate, and source or drain region of the transfer gate transistor is provided in the major surface of the substrate and separated from the high impurity region. The electrode of the capacitor within the groove is connected to the source or drain region through an contact hole provided in an insulating film formed on the major surface of the substrate. With this type of memory cells, even if an interval between the memory cells is shortened, mutual interference would not occur, and also even if the substrate is irradiated with ionizing radiations such as α-rays and the like and electric charges are generated by the irradiations within the substrate, as these electric charges would hardly enter the groove cell. Therefore, malfunctions caused by α-rays can be prevented. However, this structure has also a restriction to enhance further the integration, because an interval between the source or drain region and the high impurity region is necessary and the length of the source or drain region becomes inevitably long to form the contact hole thereon.

To solve this problem, if the source or drain region is contacted to the high impurity region which is extended up to the major surface of the substrate, the breakdown voltage therebetween decreases. Therefore, the voltage applied to the electrode of the capacitor through the transfer gate transistor must be designed to be low level..In this case, even if the capacitance of the capacitor section is large, the storage charge in the capacitor section is decreased. On the other hand, if the impurity concentration of the high impurity region layer is designed to be low level to avoid the depression of the breakdown voltage, the capacitance of the capacitor is reduced when the voltage is applied to the electrode of the capacitor due to expansion of a depletion layer produced along the groove of the substrate.

Summary of the Invention:

Accordingly, an object of the invention is to provide a dynamic memory device which can realize an enhanced high integration and in which a large amount of charges can be stored in a capacitor of each memory cell.

Another object of the invention is to provide an effective memory device which has strong immunity against ionizing irradiations.

These objects are achieved by a semiconductor device having the features indicated in claim 1, the dependent claims are related to further developments of the invention.

According to a feature of the present invention, there is provided a dynamic memory device having a plurality of one-transistor type memory cells, which comprises a semiconductor substrate having a major surface, a first portion and a second portion. The first portion of one conductivity type having a low impurity concentration is positioned along the major surface of the substrate, and the second portion of one conductivity type having a higher impurity concentration than that of the first portion is positioned under at least a part of the first portion such that the second portion is separated from the major surface. A groove is formed in the substrate from the major surface into the second portion through the part of the first portion such that a first side wall of the groove is made of the first portion of the substrate, and a second side wall of the groove under the first side groove and the bottom of the groove are made of the second portion of the substrate. An insulating film as a dielectric film of the capacitor is formed on the second side wall and on the bottom of the groove. An conductive material as an electrode of the capacitor is formed on the insulating film within the groove. An impurity region of the opposite conductivity type is formed in the major surface within the first portion of the substrate as one of source and drain regions of the transfer gate transistor. The impurity region is separated from the second portion of the substrate and contacted at its end section to a part of the first side wall of an upper portion of the groove and the conductive member is contacted to the end section of the impurity region. To avoid decreasing the capacitance by the depletion layer when a voltage is applied to the electrode of the capacitor, the impurity concentration of the second portion is favorably $10^{18}$ atoms/$cm^3$ or more. The depth of the part of the first portion above the second portion, that is, the internal between the major surface of the substrate and the second portion ranges favorably from 0.8 $\mu$m to 1.5 $\mu$m. The upper limit is defined to enhance the capacitance with a constant depth of the groove and the lower limit is defined to prevent the connection of the impurity region of source, drain region of the transistor having 0.2 to 0.5 $\mu$m depth and the second portion having a high impurity concentration so that a high breakdown voltage therebetween can be maintained. The first portion of the substrate has favorably a impurity concentration of $10^{17}$ atoms/$cm^3$ or less to obtain a desirable threshold voltage in the transistor and a sufficient high breakdown voltage level.

The first portion of the substrate may be a section of the substrate per se and the second portion of the substrate may be a impurity region which has been formed by introducing an impurity from the side and bottom of the groove. Or else, the second portion of the substrate may be a silicon body having a high impurity concentration and the first portion may be a monocrystalline layer having a low impurity concentration formed on the body by epitaxial method or the like.

Brief Description of the Drawings:

Figs. 1 to 3 are cross-sectional views showing one-transistor type memory cells in prior arts, respectively;
Fig. 4A is a plan view showing a first embodiment of the present invention, and Fig. 4B is a cross-sectional view taken along line B-B' in Fig. 4A as viewed in the direction of arrows:
Figs. 5A to 5H are cross-sectional views showing process steps for manufacturing the first embodiment of the present invention;
Fig. 6 is a cross-sectional view showing a second embodiment of the present invention; and
Figs. 7A to 7H are cross-sectional views showing process steps for manufacturing the second embodiment of the present invention.

Description of the Prior Arts:

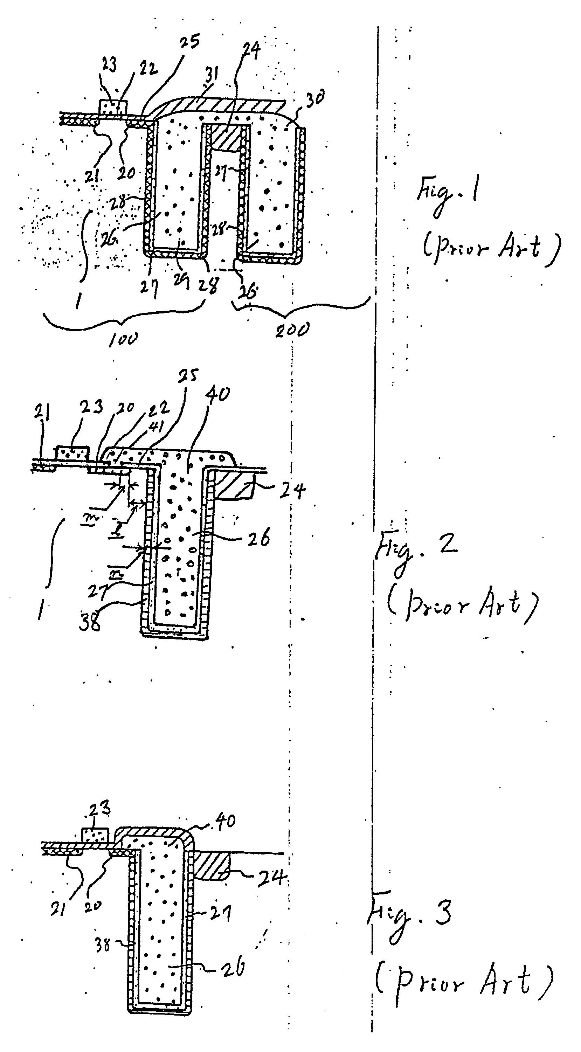

Referring to Fig. 1, one transistor-type memory cells 100, 200 are formed in a P-type silicon substrate 1 by interposing a thick silicon oxide layer 24 therebetween as a field insulating layer. Each of memory cells comprises a groove 26 provided from a major surface 25 of the substrate inwardly, a first thin insulating film 27 of silicon oxide and/or silicon nitride formed on the side surface of the groove and on the bottom of the groove as a dielectric film of the capacitor, a conductive member 30 of polycrystalline silicon formed on the first insulating film 27 within the groove 26 and filling the groove as an upper electrode of the capacitor, and an N-type inversion layer 28 produced along the groove such that it is contacted to the first insulating film 27 when a positive voltage is applied to the conductive material 30. The N-type inversion layer 28 may be formed beforehand. The conductive material 30, the first insulating film 27 and the N-type inversion layer 28 constitute a MOS capacitor of the capacitor section of the memory cell, and the N-type inversion layer 28 and a portion of the P-type substrate adjacent to the layer constitute a PN junction capacitor of the capacitor section of the memory cell. The memory cell has a transfer gate transistor which includes a pair of N-type impurity regions 20, 21 as source and drain regions, a second thin insulating film 22 as a gate insulator and a second conductive member 23 as a gate electrode. A word line (not shown) is connected to the gate electrode 23 or continuously formed with the gate electrode, and a bit line (not shown) is connected to the N-type impurity region 21. An insulating layer 31 is provided on the capacitor section. The N-type inversion layer 28 is connected to the N-type impurity region 20 of one of source and drain regions of the transfer gate transistor. The structure can realize a high integration because of using the groove as the capacitor section. However, electric charges are stored in the N-type inversion layer 28. Therefore, if the interval between grooves belonging to respective memory cells is shortened such as about 1 $\mu$m, an interference between memory cells is caused. Further, a necessary immunity against ionizing radiations such as $\alpha$-rays cannot be expected.

To solve these problems, a memory cell shown in Fig. 2 has been proposed. In Fig. 2, the same components like those in Fig. 1 have been identified with like numerals. A P$^+$-type impurity portion 38 having a higher impurity concentration than that of the P-type silicon substrate 1 is provided along the groove 26 such that it is contacted to the first insulating film 27, and the first conductive member 40 is connected to the N-type impurity region 20 through a contact hole 41 formed in the second thin insulating film 22 provided on the major surface 25 of the substrate. In the memory cell, the first conductive member 40 as an electrode, the first insulating film 27 as a dielectric film and the P$^+$-type impurity portion 38 constitute a MOS capacitor of the memory cell, and therefore any interference does not cause even if the interval between the memory cells is shortened such as 0.5 $\mu$m. Further, an immunity against ionizing radiations become strong. However, the N-type impurity region 20 is separated from the P$^+$-type high impurity portion 38 at a distance $\ell$, and a length m of the N-type impurity region between an end of the contact hole 41 and an end of the region is necessary. Further, the P$^+$-type high impurity portion 38 extends up to the major surface 25 of the substrate with a depth n. If a necessary high breakdown voltage between the N-type impurity region 20 and the P$^+$-type high impurity portion 38 and photolithography conditions are considered, the dimensions of $\ell$, m and n become 0.8 to 1.5 $\mu$m, about 0.5 $\mu$m and about 1.0 m, respectively. Therefore, the memory cell shown in Fig. 2 cannot realize further enhanced high integration by the restriction of the dimensions of $\ell$, m and n.

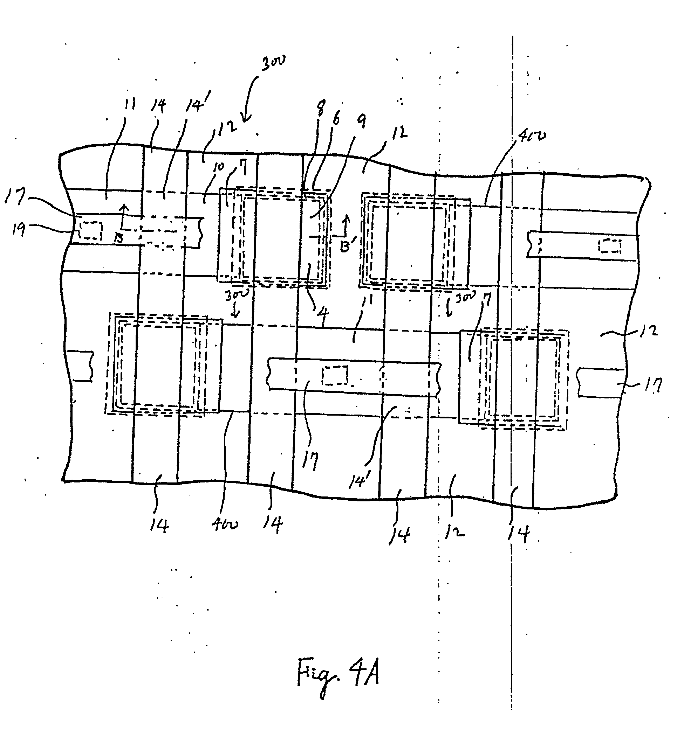

On the other hand if we attempt to contact the N-type impurity region 20 to the P$^+$-type impurity portion 38 as shown in Fig. 3 to eliminate the above-mentioned restriction about the dimensions, the breakdown voltage between the N-type region 20 and the P$^+$-type portion 38 decreases such as 2 volt. Therefore, as a signal voltage applied to the electrode 40 through the transfer gate cannot be used a normal voltage of 5 volt but is restricted to 2 volt or less. In this case, even if a capacitance per se of the capacitor section maintains a normal value, a large amount of carriers cannot be stored in the capacitor. More particularly, if the plan area of the groove is 1.2 $\mu$m x 1.2 $\mu$m and the height thereof is 5$\mu$m. The thickness of the first insulating film 27 is 200 Å (20nm) as transformed to an SiO$_2$ film, and the impurity concentration of the P$^+$-type high impurity portion is 1 x 10$^{19}$ atoms/cm$^3$. When a positive signal voltage of 2 volt is applied through the transfer gate transistor to the electrode 40, the capacitance of the capacitor section becomes 42 fF (42 x 10$^{-15}$ farad). Whereas, a small amount of storage carriers such as 84 fC (2 x 42 x 10$^{-15}$ coulomb) is only obtained by the low voltage of 2 volt.

Detailed Description of the Embodiment:

First Embodiment:

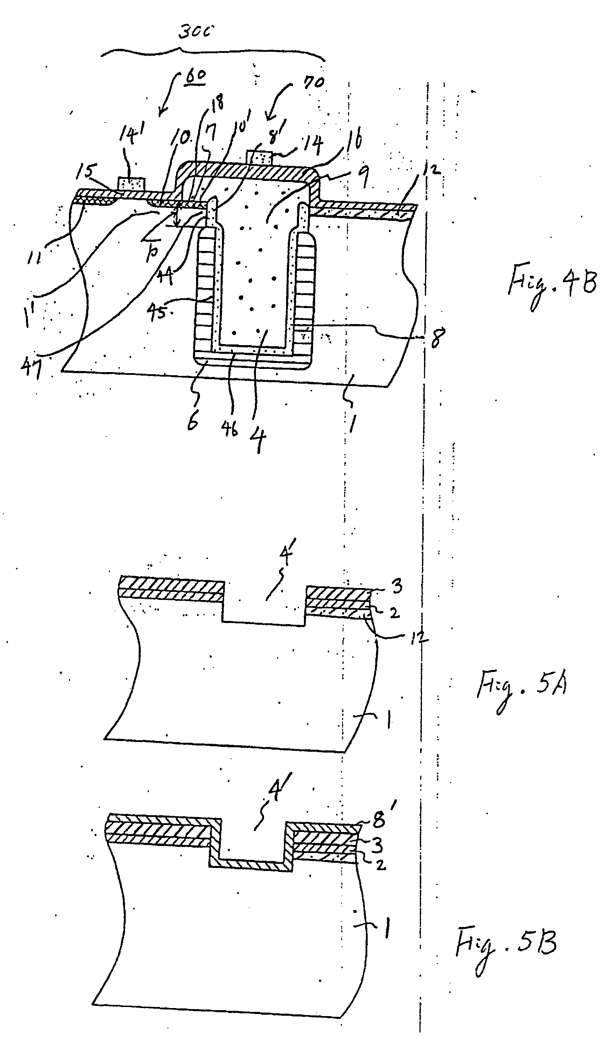

Referring to Figs. 4A and 4B, a plurality of active regions 400 are formed in a P-type silicon substrate 1 and surrounded by a field insulating layer 12. In each the active regions 400, two of one-transistor type dynamic memory cells 300 are provided. A plurality of word lines 14 extend in a first direction and a plurality of bit lines 17 extend in a second direction right angles to the first direction and connected to source or drain regions 11 through contact portions 19. Each memory cell 300 consists of a single transfer gate transistor 60 and a single MOS type capacitor 70 connected to the transistor 60. The transistor 60 includes N-type impurity regions 10, 11 as source, drain regions formed in a low impurity first portion 1' of P-type in the substrate 1 along a major surface 18 of the substrate, a gate insulating film 15 of silicon oxide, and a gate electrode 14' of polycrystalline silicon which is a part of the word line 14. A groove 4 is formed from the major surface 18 into a second portion 6 of P$^+$-type having a higher impurity concentration than that the first portion through a part 47 of the first portion 1' such that a first side wall 44 of the groove 4 is made of the first portion 1' of the substrate 1, and a second side wall 45 of the groove 4 under the first side wall 44 and the bottom 46 of the groove 4 are made of the second portion 6 in the substrate 1. A first insulating film 8 is formed on the second side wall 45 and on the bottom 46 of the groove 4, entirely. A second insulating film 8' is formed on the first side wall 44 of the groove. A conductive member 9 of N-type polycrystalline silicon is formed on the first and second insulating films 8, 8', fills the groove 4 and connected to the end section 10' of the N-type impurity region 10 as one of source and drain regions of the transistor 60 at a contact part 7. The first insulating film 8 is used as a dielectric film of the MOS capacitor 70, and the conductive member 9 is used as an electrode of the capacitor 70. The first insulating film 8, that is, the dielectric film 8 may be made of silicon oxide and/or silicon nitride. The first portion 1' of P-type has a impurity concentration of $10^{17}$ atoms/cm³ or less, for example, 1 to 5 x $10^{15}$ atoms/ cm³ and in which the transistor 60 is formed. The second portion 6 of $P^+$-type has a higher impurity concentration of $10^{18}$ atoms/cm³ or more, for example, $10^{19}$ to $10^{20}$ atoms/cm³ and separated from the major surface 18 with an interval P of 0.8 to 1.5 $\mu$m. On the other hand, the N-type region 10 as one of source and drain regions of the transistor is contacted at its end section 10' to an upper part of the first side wall 44 the groove 4, and the electroce 9 of the capacitor is contacted to the upper surface 7 of the end section 10' of the N-type region 10. An insulating layer 16 is formed or the capacitor section.

According to the embodiment of the present invention, the restriction by dimensions $l$, m, n in Fig. 2 is eliminated. Therefore, the integration can be further enhanced. Moreover, the N-type region 10 (10') and the second portion 6 of $P^+$-type having a high impurity concentration are separated from each other. Therefore, the breakdown voltage therebetween becomes high and a signal voltage such as 5 volt can be applied to the electrode 9 through the transfer gate transistor 60. Then, a large amount of carriers can be stored in the capacitor 70. More particularly, if the plan area of the groove 4 is 1.2 $\mu$m x 1.2 $\mu$m and height consisting of the first and second side walls thereof is 5$\mu$m. The thickness of the dielectric film 8 is 200 Å (20nm) as transformed to an $SiO_2$ film, and the impurity concentration of the second portion 6 of $P^+$-type is 1 x $10^{19}$ atoms. When a positive signal voltage of 5 volt is applied to the electrode 9 through the transfer gate transistor 60, the capacitance of the capacitor 70 become 35 fF (35 x $10^{-15}$ farad). The depression of the capacity per se in comparison with the memory cell in Fig. 3 is due to the interval p due to the part 47 of the first portion in Fig. 4B and increasing a depletion layer (not shown) along the groove by applying a high voltage (5 volt). However, according to the embodiment, a large amount of carriers such as 175 fC (5 x 35 x $10^{-15}$ coulomb), which is about twice the value of Fig. 3, can be stored in the capacitor 70.

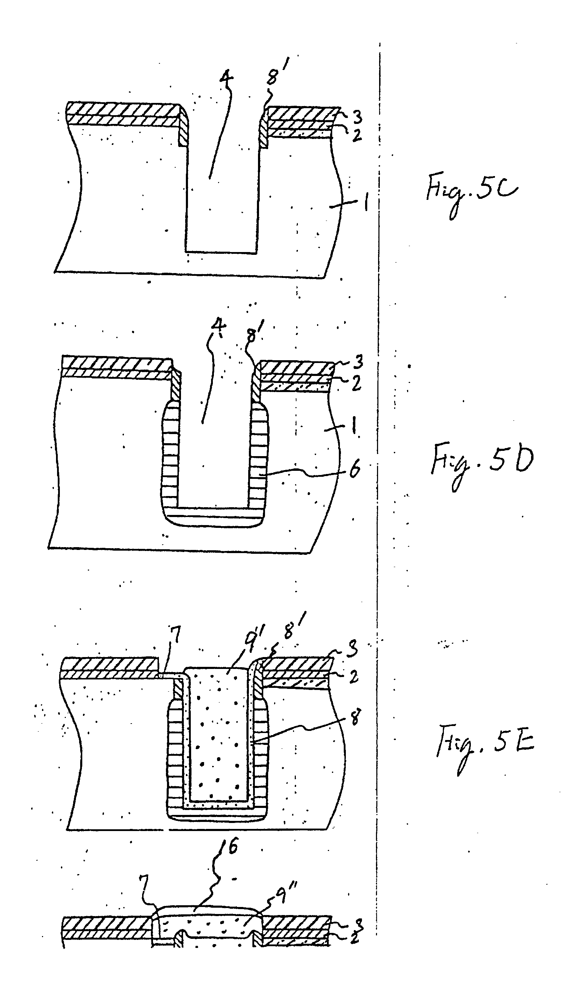

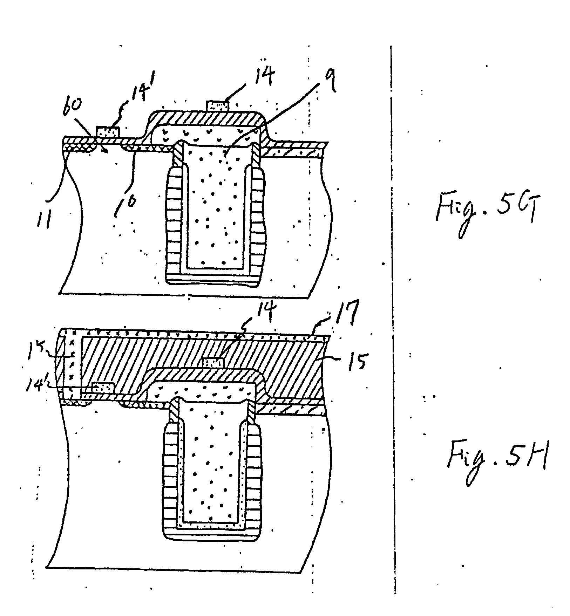

In Figs. 5A to 5H, the manufacturing steps for forming a memory cell having the structure shown in Figs. 4A and 4B will be explained in sequence. In the embodiment, an n-channel cell making use of a P-type substrate as a semiconductor substrate 1 is chosen by way of example. However, in the case of a P-channel type, it is only necessary to replace P for n.

At first, after an $SiO_2$ film 2 and an $Si_3N_4$ film 3 are formed on a surface of a P-type single crystal silicon substrate 1, in which a field insulating layer 12 has been selectively formed beforehand, having an impurity concentration of about 1 to 5 x $10^{15}$ atoms/cm³, the $Si_3N_4$ film 3, the $SiO_2$ film 2 and the silicon substrate 1 in a desired region are successively etched by making use of the well-known photo-etching technique, and thereby a first groove 4' is formed, as shown in Fig. 5A. Preferable thicknesses of the $SiO_2$ film 2 and the $Si_3N_4$ film 3 are about 500 Å (50nm) and about 1000 Å (100nm), respectively. With regard to the depth of the groove provided in the silicon substrate 1, no special limitation is imposed thereon, but preferably etching should be effected by about 1 to 2 $\mu$m (First Groove Formation).

Next, as shown in Fig. 5B, an $SiO_2$ film 8' is formed over the entire surface of the wafer. This $SiO_2$ film 5 is used as a mask for preventing diffusion of boron to a side wall of the groove. It is necessary to form the $SiO_2$ film 8' on the groove side wall, and it could be formed through a thermal oxidation process, a reduced-pressure vapor growth process or the like, or else after a polysilicon film has been once formed, it could be transformed into an $SiO_2$ film 8' by thermal oxidation. Alternatively, furthermore an $Si_3N_4$ film could be formed to provide a double layer structure film consisting of an $SiO_2$ film and an $Si_3N_4$ film. This film suffices for the necessity of preventing diffusion of boron, if it is provided by a thickness of about 1000 ~ 3000 Å (100 ~ 300 nm).

Subsequently, as shown in Fig. 5C, the first groove 4' is etched deeper by an anti-isotropic reactive ion etching, and thereby a second groove 4 is formed (Second Groove Formation). At this time, the $SiO_2$ film 8' at the bottom of the first groove 4' is etched away, and then etching of the Si substrate 1 proceeds, but since the $SiO_2$ film 8' at the groove side wall is hard to be etched, it is sufficiently useful as a mask for the subsequent diffusion.

Then, as shown in Fig. 5D, an inner second side wall of the groove 4 formed by the second groove formation, is doped with boron to a concentration of $10^{18}$ to $10^{20}$ atoms/cm³ to form a $P^+$-type portion 6. At this time, the $SiO_2$ film 8' left at the side wall of the first groove 4 serves as a mask for diffusion of boron, and hence, boron cannot be diffused into this first side wall portion. Therefore, the $P^+$-type portion 6 is formed only at the inner wall of a lower portion, that is, the second side wall of the groove 4.

Next, as shown in Fig. 5E, in order to form a contact part 7 at an end portion of a groove capacitor, the $SiO_2$ film 2 and the $Si_3N_4$ film 3 are selectively removed, and then a capacitor insulating film 8 is formed. For this capacitor insulating film 8, either an SiO₂ film obtained by thermally oxidizing the substrate may be used or a double layer structure consisting of an SiO₂ film and an Si₃N₄ film may be employed, and the choice could be done arbitrarily. A film thickness of the capacitor insulating film 8 should be preferably about 100 to 200 Å (10 to 20 nm) as transformed to an SiO₂ film. Next, after polycrystalline silicon 9' has been vapor-grown over the entire surface of the wafer, the polycrystalline silicon on the surface of the Si₃N₄ film 3 is removed and the groove 4 is filled up with polycrystalline silicon 9'. In the event that the groove 4 cannot be filled up with polycrystalline silicon 9' in one process, then by repeating the vapor growth and the etching several times the groove can be filled up with polycrystalline silicon 9'. The polycrystalline silicon 9' is doped with an impurity such as phosphorus or the like to transform it sufficiently to n-type, during formation of the film or after formation of the film.

Subsequently, referring to Fig. 5F, after a contact part 7 has been exposed again by the photo-etching technique, a polycrystalline silicon film 9" is formed, and in succession, a polycrystalline silicon electrode 9 in Fig. 4 by film 9' and film 9" is formed by the photo-etching technique. This polycrystalline silicon electrode 9 is kept in contact with the substrate 1 through the contact part 7, and an $n^+$ diffusion layer 10', which is the end section 10' of the impurity region 10 in Fig. 4B, is formed on the surface of the substrate at the contact hole portion 7 as a result of the fact that the n-type impurity in the polycrystalline silicon electrode diffuses. At this time, the $n^+$ diffusion layer 10' of 0.3 to 0.5 $\mu$m depth and the $P^+$ diffusion portion 6 are separated from each other by about 0.5 to 1 $\mu$m so that a sufficient withstand voltage can be obtained. Subsequently, an SiO₂ layer 16 of about 3000 to 6000 Å (300-600 nm) in thickness is formed further by thermal oxidation because word lines and bit lines are to be formed on the polycrystalline silicon electrode 9.

Next, referring to Fig. 5G, after the Si₃N₄ film 3 and the SiO₂ film 2 which form the first coating film have been etched away, an n-channel MOS FET 60 to be used as a transfer gate transistor is formed through the conventional process. In the case where a folded bit line type cell structure is employed, the gate electrode 14' of that MOS FET 60 serves as a word line 14, and a word line of the adjacent cell is disposed above the polycrystalline silicon electrode 9 by the intermediary of the SiO₂ layer 16.

Finally, as shown Fig. 5H, an interlayer insulator film 15 is formed, and after a desired contact hole has been formed, a bit line is formed of an aluminium wiring 17.

As described above, after formation of a first groove, while retaining an impurity diffusion mask on a side wall the groove is dug deeper by an anti-isotropic reactive ion etching in a second groove formation step, thereafter a $P^+$ diffusion portion is formed only in a deep portion of the groove by introducing a P-type impurity, and thereby a sufficient distance can be maintained between the $P^+$ diffusion portion and an $n^+$ diffusion layer serving as a source or a drain of a MOS FET. Accordingly, a withstand voltage between the $P^+$ diffusion portion and the $n^+$ diffusion layer is improved, and disappearance of information can be prevented. In the semiconductor device according to the present invention, the depth of formation of the $P^+$ portion is determined by the depth of the groove in the groove formation steps. Since the depth of the groove can be well controlled, the subject devices can be realized with a good yield.

According to the present invention, owing to the fact that a high concentration impurity region in a groove capacitor section and a source/drain region in a transistor section can be separated from each other in the vertical direction, a breakdown voltage at this portion can be improved. In addition, since an occupation area per cell can be reduced, a D-RAM having a high density can be realized.

Second Embodiment:

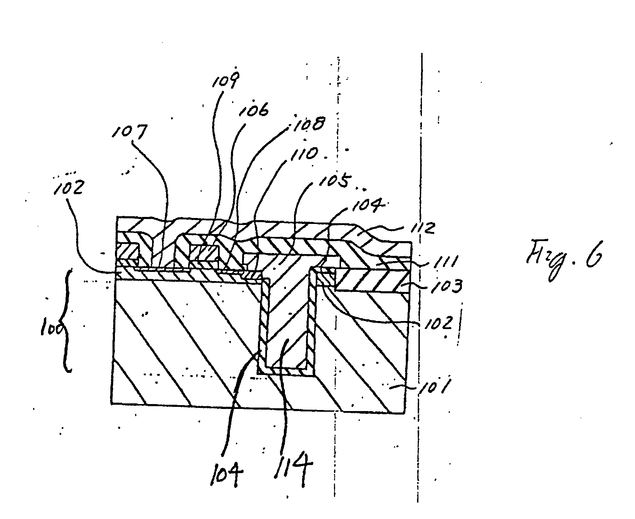

Referring to Fig. 6, a semiconductor substrate 100 comprises a $P^+$-type silicon body 101 having a specific resistivity of 0.001 to 0.01 $\Omega$-cm, that is, an impurity concentration of about $10^{19}$ to $10^{20}$ atoms/cm³ and a P-type monocrystalline silicon layer 102 having a specific resistivity of 3 x 0.1 to 10 $\Omega$-cm, that is, an impurity concentration of about $10^{15}$ to $10^{17}$ atoms/cm³ formed on the silicon body 101. An field silicon oxide layer 103 of 0.2 to 1.0 $\mu$m thickness is selectively formed on the surface of the substrate 100. A groove 114 of 2 to 10 $\mu$m depth is formed from a major surface of the substrate 100, that is, a surface of the silicon layer 102 into the $P^+$-type silicon body, and a dielectric film 104 of silicon oxide and/or silicon nitride is provided on the side surface and the bottom of the groove 114. On the dielectric film 104 is formed an electrode 105 of a capacitor by depositing N-type polysilicon. The capacitor of the memory cell is constituted by the electrode 105, the dielectric film 104 and $P^+$-type silicon body 101. On the other hand, the transfer gate transistor is constituted by N-type source and drain regions 107 and 108 formed in the P-type silicon layer 102, a gate insulating film 109 and a gate electrode 106. More particularly, one of source and drain regions includes an N-type region 108 facing to the channel region and an N-type contact region 110 contacted to an upper part of the groove 114 to which the N-type polysilicon electrode 105 of the capacitor is connected. Over the transistor and the capacitor, an insulating layer 111 is formed, and a bit line 112 is formed on the insulating layer 111 and connected to the other region 107 of source and drain regions.

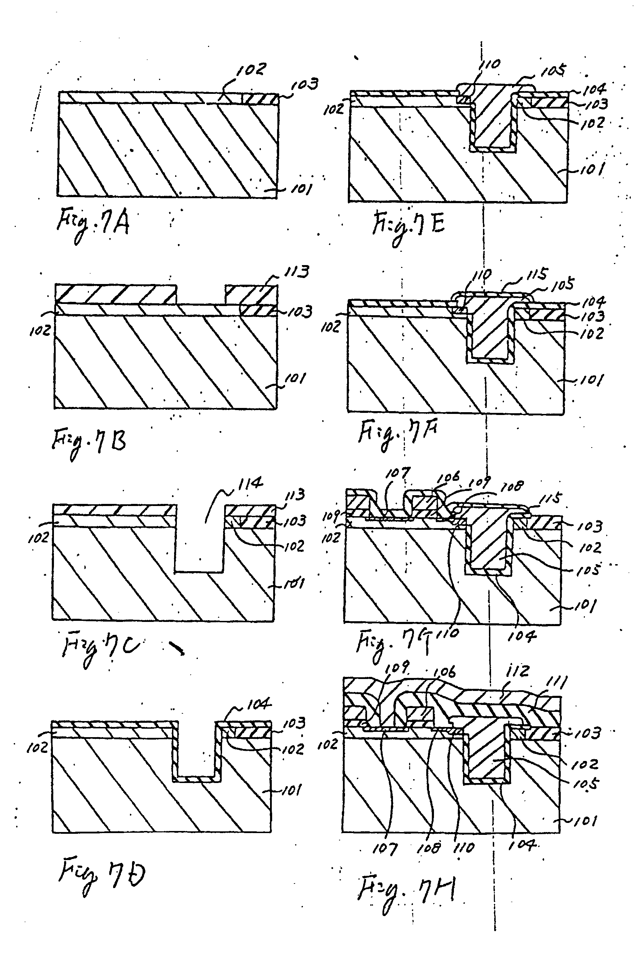

Referring to Figs. 7A to 7H, process steps for manufacturing the second embodiment will be explained. At first as shown in Fig. 7A, the P-type silicon layer 102 is formed on the P⁺-type silicon body 101 by an epitaxial grown method or CVD method, and the field silicon oxide layer 103 is selectively formed. After a photoresist pattern 113 is formed as shown in Fig. 7B, a reactive ion etching is conducted to form the groove 114 by using the photoresist pattern 113 as a mask as shown in Fig. 7C. Next, as shown in Fig. 7D, the dielectric film 104 is entirely formed. Referring to Fig. 7E, after removing a part of the film 104 where the contact region 110 is to be formed, the polycrystalline silicon layer 105 doped by N-type impurity such as phosphorous or arsenic is formed over the dielectric film 104 to form the capacitor electrode, and from the N-type silicon electrode 105, an N-type impurity is diffused to form N⁺-type contact region 110. After a thermal silicon oxide film 115 is formed on the polysilicon electrode 105 as shown in Fig. 7F, on the P-type silicon layer 102, the gate electrode 106 of polysilicon or silicide of high melting point metal via the gate insulating film 109. The N-type source and drain regions 107, 108 are formed by using the gate electrode 106 as a mask such as the region 108 being contacted to the contact region 110 as shown in Fig. 7G. Then, as shown in Fig. 7H, after depositing the insulating layer 111 by a CVD method, the bit line 112 made of aluminum, high melting point metal or the like is formed on the layer 111 and connected to the N-type region 107.

## Claims

1. A dynamic memory device comprising a semiconductor substrate (1, 100) having a major surface (18), said substrate (1, 100) including a first portion (1', 102) of one conductivity type and a second portion (6, 101) of one conductivity type having a higher impurity concentration than that of said first portion (1', 102) and separated from said major surface (18) of said substrate (1, 100) by interposing a part of said first portion (1', 102), a groove (4, 114) provided from said major surface (18) of said substrate (1, 100) into said second portion (6, 102) through said part of said first portion (1', 102) such that a first side wall (44) of said groove (4, 114) is made of said first portion (1', 102) and a second side wall (45) under said first side wall (44) and the bottom (46) of said groove (4, 114) are made of said second portion (6, 101), a first insulating film (8, 104) formed on said second side wall (45) of said groove (4, 114) and on said bottom (46) of said groove (4, 114), an impurity region (10, 108) of the opposite conductivity type formed in said first portion (1', 102), separated from said second portion (6, 101) and contacted at its end section (10', 110) to a part of said first side wall (44) of said groove (4, 114), and a conductive member (9, 105) formed on said insulating film (8, 104) within said groove (4, 114) and connected to said end section (10', 110) of said impurity region (10, 108), whereby said first insulating film (8, 104) and said conductive member (9, 105) within said groove (4, 114) constitute a dielectric film (8, 104) and an electrode (9, 105) of a capacitor of a memory cell (300), respectively, and said impurity region (10, 108) is one of source and drain regions of a transfer gate transistor (60) of said memory cell (300).

2. A dynamic memory device of claim 1, in which said impurity concentration of said second portion (6, 101) is $10^{18}$ atoms/cm³ or more.

3. A dynamic memory device of claim 1, in which the depth of said part of said first portion (1', 102) above said second portion (6, 101) ranges from 0,8 μm to 1,5 μm.

4. A dynamic memory device of claim 1, in which the impurity concentration of said first portion (1', 102) is $10^{17}$ atoms/cm³ or less.

5. A dynamic memory device of claim 1 further comprising a second insulating film (8', 104) formed on said first side wall (44) of said groove (4, 114).

## Revendications

1. Dispositif de mémoire dynamique comprenant un substrat semi-conducteur (1, 100) comportant une surface principale (18), le substrat (1, 100) comportant une première portion (1', 102) d'un premier type de conductivité et une seconde portion (6, 101) d'un premier type de conductivité présentant une concentration d'impuretés plus élevée que celle de la première portion (1', 102) et séparé de la surface principale (18) du substrat (1, 100) par l'interposition d'une partie de la première portion (1', 102), une rainure (4, 114) creusée depuis la surface principale (18) du substrat (1, 100) dans la seconde portion (6, 102) à travers la partie de la première portion (1', 102) telle qu'une première paroi latérale (44) de la rainure (4, 114) est constituée de la première portion (1', 102) et qu'une seconde paroi latérale (45) sous la première paroi latérale (44) et le fond (46) de la rainure (4, 114) sont constituées de la seconde portion (6, 101), un premier film isolant (8, 104) formé sur la seconde paroi latérale (45) de la rainure (4, 114) et sur le fond (46) de la rainure (4, 114), une région d'impuretés (10, 108) du type de conductivité opposée formée dans la première portion (1', 102), séparée de la seconde portion (6, 101) et mise en contact au niveau de sa section d'extrémité (10', 110) à une partie de la première paroi latérale (44) de la rainure (4, 114), et un élément conducteur (9, 105) formé sur le film isolant (8, 104) à l'intérieur de la rainure (4, 114) et connecté à la section d'extrémité (10', 110) de la région d'impuretés (10, 108), si bien que le premier film isolant (8, 104) et l'élément conducteur (9, 105) à l'intérieur de la rainure (4, 114) constituent un film diélectrique (8, 104) et une électrode (9, 105) d'un condensateur d'une cellule de mémoire (300), respectivement, et la région d'impuretés (10, 108) est une région des régions de source et de drain d'un transistor de grille de transfert (60) de la cellule de mémoire (300).

2. Dispositif de mémoire dynamique selon la revendication 1, dans lequel la concentration d'impuretés de la seconde portion (6, 101) est de $10^{18}$ atomes/cm³ ou plus.

3. Dispositif de mémoire dynamique selon la revendication 1, dans lequel la profondeur de la partie de la première portion (1', 102) au-dessus de la seconde portion (6, 101) est comprise entre 0,8 μm à 1,5 μm.

4. Dispositif de mémoire dynamique selon la revendication 1, dans lequel la concentration d'impuretés de la première portion (1', 102) est de $10^{17}$ atomes/cm³ ou moins.

5. Dispositif de mémoire dynamique selon la revendication 1, comprenant de plus un second film isolant (8', 104) formé sur la première paroi latérale (44) de la rainure (4, 114).

**Patentansprüche**

1. Dynamische Speicheranordnung mit einem Halbleitersubstrat (1,100) mit einer Hauptfläche (18), wobei das Substrat (1,100) aufweist einen ersten Abschnitt (1', 102) vom einen Leitertyp und einen zweiten Abschnitt (6, 101) vom einen Leitertyp mit einer höheren Fremdatomkonzentration als die des ersten Abschnittes (1', 102), der von der Hauptfläche (18) des Substrats (1,100) durch Dazwischenliegen eines Teils des ersten Abschnittes (1', 102) getrennt ist, eine Nut (4,114), die von der Hauptfläche (18) des Substrats (1,100) über den besagten Teil des ersten Abschnittes (1', 102) in dem zweiten Abschnitt (6,102) gebildet ist, so daß eine erste Seitenwand (44) der besagten Nut (4,114) aus dem ersten Abschnitt (1', 102) und eine zweite Seitenwand (45) unter der ersten Seitenwand (44) und der Boden (46) der Nut (4,114) aus dem zweiten Abschnitt (6,101) bestehen, auf der zweiten Seitenwand (45) und dem Boden (46) der Nut (4,114) eine erste Isolierschicht (8,104) ausgebildet ist, einen Fremdatombereich (10,108) vom entgegengesetzten Leitertyp, der in dem ersten Abschnitt (1', 102), welcher vom zweiten Abschnitt (6,101) getrennt ist, ausgebildet ist, und an seinem Endabschnitt (10',110) mit einem Teil der ersten Seitenwand (44) der Nut (4,114) kontaktiert ist, und ein leitfähiges Element (9,105), das auf der Isolierschicht (8,104) innerhalb der Nut (4,114) ausgebildet ist, und an den Abschnitt (10',110) des Fremdatombereiches (10,108) angeschlossen ist, wobei die erste Isolierschicht (8,104) und das leitfähige Element (9,105) innerhalb der Nut (4,114) jeweils eine dielektrische Schicht (8,104) und eine Elektrode (9,105) eines Kondensators einer Speicherzelle (300) bilden, und der Fremdatombereich (10,108) entweder der Source- oder Drainbereich eines Übertragungs - Gate - Transistors (60) der Speicherzelle (300) ist.

2. Dynamische Speicheranordnung nach Anspruch 1, in welcher die Fremdatomkonzentration des zweiten Abschnittes (6,101) $10^{18}$ Atome/cm³ oder mehr beträgt.

3. Dynamische Speicheranordnung nach Anspruch 1, in welcher die Tiefe des besagten Teils des ersten Abschnittes (1',101) oberhalb des zweiten Abschnittes (6,101) im Bereich von 0,8μm bis 1,5μm liegt.

4. Dynamische Speicheranordnung nach Anspruch 1, in welcher die Fremdatomkonzentration des ersten Abschnittes (1',102) $10^{17}$ Atome/cm³ oder weniger beträgt.

5. Dynamische Speicheranordnung nach Anspruch 1, die weiterhin eine zweite Isolierschicht (8',104) aufweist, die auf der ersten Seitenwand (44) der Nut (4,114) ausgebildet ist.

Fig. 1

(Prior Art)

Fig. 2

(Prior Art)

Fig. 3

(Prior Art)

9

Fig. 4A

Fig. 4B

Fig. 5A

Fig. 5B

Fig. 5C

Fig. 5D

Fig. 5E

Fig. 5G

Fig. 5H

Fig. 6

Fig. 7A

Fig. 7B

Fig. 7C

Fig. 7D

Fig. 7E

Fig. 7F

Fig. 7G

Fig. 7H